# EUROPEAN PATENT APPLICATION

(11) **EP 2 733 768 A1**
(43) Date of publication of application: **21.05.2014**
(21) Application number: 13157594.6
(22) Date of filing: 04.03.2013
(51) Int. Cl.: H01M 2/10, H04M 1/02

(54) **Hand-held electronic device and battery unit**

(30) Priority: 16.11.2012 JP 2012252594
(71) Applicant: NINTENDO CO., LTD., Minami-ku, Kyoto 601 (JP)
(72) Inventor: Kumazaki, Daisuke, Kyoto, 601-8501 (JP); Takamoto, Junji, Kyoto, 601-8501 (JP); Nishimura, Masahiko, Kyoto, 601-8501 (JP); Goto, Yoshitomo, Kyoto, 601-8501 (JP); Okamura, Takanori, Kyoto, 601-8501 (JP)
(74) Representative: Lang, Johannes

(57) **Abstract**

A hand-held electronic device includes a battery accommodating portion provided with an attaching portion which is formed in a rectangular shape in plain by longer first sides and shorter second sides, and formed with concave portions at corresponding positions on the first sides. A first battery unit is attached to the attaching portion by fitting first ends which form shorter sides of the first battery unit into the concave portions. When a second battery unit is to be attached to the same attaching portion, a second battery unit is attached within the first sides and the second sides without using the concave portions.

## Description

### Field of the invention

The present invention relates to a hand-held electronic device using a battery and a battery unit, and more specifically, a hand-held electronic device using a battery, in which a battery unit is accommodated in a battery accommodating portion provided on a housing, and a battery unit.

### Background arts

One example of background arts is disclosed in a Patent document 1 (Japanese Patent Application Laying-open No. 2009-32595). In the patent document 1, there is disclosed portable electronic equipment in which a battery pack is accommodated in a battery pack accommodating portion, and in such a state, a battery cover is attached to a case.

In the electronic equipment disclosed in the patent document 1, only one kind of a battery pack can be utilized.

### SUMMARY OF THE INVENTION

It is a primary object of embodiments to provide a novel hand-held electronic device using a battery and a battery unit.

It is another object of the embodiments to provide a hand-held electronic device using a battery and a battery unit, capable of making two kinds of battery units different from each other in shape available.

It is the other object of the embodiments to provide a battery unit which can be accommodated in an accommodating portion capable of making two kinds of battery units deferent from each other in shape available.

It should be noted that reference numerals and the supplements inside the parentheses show an example of a corresponding relationship with the embodiments described later for easy understanding of the present invention, and do not limit the present invention.

A first invention is a hand-held electronic device having a housing capable of being held by one hand or both hands, and a battery unit is accommodated within a battery accommodating portion provided on the housing, comprising: an attaching portion which is provided in the battery accommodating portion in a rectangular shape defined by two first sides and two second sides each of which is shorter than each of the first sides; a concave portion which is formed on at least one of the first sides of the attaching portion with a predetermined height and a predetermined width; and a first battery unit or a second battery unit capable of selectively being attached to the attaching portion, wherein the first battery unit includes a main body which has two first ends each having a length according to a total length of a length of one of the second sides of the attaching portion and the height of the concave portion and two second ends each of which is shorter than each of the first ends, the second battery unit includes a main body which has two first ends each having a length according to a length of one of the second sides of the attaching portion and two second ends each having a length according to a length of one of the first sides of the attaching portion, and the first battery unit is attached to the attaching portion in a manner that one of the second ends of the main body is along with the concave portion and the second battery unit is attached to the attaching portion in a manner that the first ends of the main body are along with the second sides and the second ends are along with the first sides.

According to the first invention, it is possible to selectively attach two kinds of battery units different from each other in shape to a single attaching portion.

A second invention is a hand-held electronic device according to the first invention, wherein the first battery unit includes longer sides formed by the first ends and the second battery unit includes longer sides formed by the second ends, and the first battery unit or the second battery unit is attached to the attaching portion in a manner that the longer sides of the first battery unit and the longer sides of the second battery unit are intersected to each other.

According to the second invention, since it is possible to attach the first battery unit or the second battery unit to the attaching portion with being clearly distinguished, an error in being attached hardly occurs.

A third invention is a hand-held electronic device according to the first invention or the second invention, wherein the attaching portion includes a first concave portion and a second concave portion respectively formed at corresponding positions on the two first sides, and the two second ends of the main body of the first battery unit are received by the first concave portion and the second concave portion, respectively.

According to the third invention, a stability at a time that the first battery unit is attached increases.

A fourth invention is a hand-held electronic device according to the third invention, wherein the first concave portion and the second concave portion are different from each other in width.

According to the fourth invention, by distinguishing which one is smaller (larger) out of widths of the concave portions, it is possible to easily recognize a correct attaching direction of the first battery unit.

A fifth invention is a hand-held electronic device according to any one of the first to fourth inventions, wherein a left and a right of the first concave portion are respectively defined by corner portions and a left and a right of the second concave portion (20b) are respectively defined by corner portions, one of the corner portions defining the first concave portion and one of the corner portions defining the second concave portion are formed at corresponding positions, and another of the corner portions defining the second concave portion is formed at a position inner than another of the corner portions defining the first concave portion.

According to the fifth invention, it is possible to prevent erroneous attaching of the first battery unit because shapes (positions) of the two concave portions are different from each other.

A sixth invention is a hand-held electronic device according to the fifth invention, wherein one of the second ends of the first battery unit is formed with a step portion which is engaged to the corner portions.

According to the sixth invention, it is possible to further prevent erroneous attaching of the battery unit by the step portion and increase a stability of the attaching of the first battery unit by an engagement of the step portion and the corner portions.

A seventh invention is a hand-held electronic device according to any one of the first to sixth inventions, wherein the sides defining the attaching portion have a predetermined depth and the main body of each of the first battery unit and the second battery unit has a thickness according to the depth.

According to the seventh invention, it is possible to use the same battery lid even if either one of the first battery unit and the second battery unit is attached.

A eighth invention is a hand-held electronic device according to any one of the first to seventh inventions, wherein each of the first battery unit and the second battery unit includes power wires which output a battery voltage and a signal wire which outputs an identification signal for identifying the first battery unit or the second battery unit.

According to the eighth invention, it is possible to correctly determine whether the first battery unit is attached or the second battery unit is attached by detecting the unique identification signal.

A ninth invention is a hand-held electronic device according to any one of the first to eighth inventions, wherein one of the second sides is formed with a cut-away portion, and each of the first battery unit and the second battery unit includes a projecting portion which is formed on the main body at a position corresponding to the cut-away portion to draw the power wires and the signal wire.

According to the ninth invention, the wires drawn out from the projecting portion can be withdrawn through the cut-away portion.

A tenth invention is a battery unit used in a hand-held electronic device having a housing capable of being held by one hand or both hands, an attaching portion which is provided in a battery accommodating portion formed on the housing in a rectangular shape defined by two first sides and two second sides shorter than the first sides and a concave portion which is formed on at least one of the first sides of the attaching portion with a predetermined height and a predetermined width, comprising: a main body which has two first ends each having a length according to a total length of a length of one of the second sides and the height of the concave portion and two second ends shorter than the first ends, wherein the battery unit is attached to the attaching portion in a manner that one of the second ends of the main body is along with the concave portion.

An eleventh invention is a battery unit according to the tenth invention, wherein the attaching portion of the hand-held electronic device includes a first concave portion and a second concave portion respectively formed at corresponding positions on the two first sides, and the two second ends of the main body of the battery unit are received by the first concave portion and the second concave portion, respectively.

A twelfth invention is a battery unit according to the eleventh invention, wherein a left and a right of the first concave portion are respectively defined by corner portions and a left and a right of the second concave portion are respectively defined by corner portions, one of the corner portions defining the first concave portion and one of the corner portions defining the second concave portion are formed at corresponding positions, and another of the corner portions defining the first concave portion is formed at a position inner than another of the corner portions defining the second concave portion, and one of the second ends of the main body is formed with a step portion which is engaged to said another of the corner portions defining the second concave portion.

A thirteenth invention is a battery unit according to the twelfth invention, wherein a hole is formed in a deeper portion of one of the first concave portion and the second concave portion, further comprising a projection which is formed on one of the two second ends and engaged to the hole when the battery unit is attached to the attaching portion.

A fourteenth invention is a battery unit according to any one of the tenth to thirteenth inventions, further comprising power wires which output a battery voltage and a signal wire which outputs a unique identification signal; and a projecting portion formed on one of the first ends to draw out the power wires and the signal wire from the main body.

A fifteenth invention is a battery unit used in a hand-held electronic device having a housing capable of being held by one hand or both hands, an attaching portion which is provided in a battery accommodating portion formed on the housing in a rectangular shape defined by two first sides and two second sides shorter than the first sides and a concave portion which is formed on at least one of the first sides of the attaching portion with a predetermined height and a predetermined width, comprising: a main body which has two first ends each having a length according to a length of one of the second sides of the attaching portion and two second ends each having a length according to a length of one of the first sides of the attaching portion, wherein the battery unit is attached to the attaching portion in a manner that the first ends of the main body are along with the first sides and the second ends are along with the second sides.

A sixteenth invention is a battery unit according to the fifteenth invention, further comprising two power wires which output a battery voltage and a signal wire which outputs a unique identification signal.

A seventeenth invention is a battery unit according to the sixteenth invention, further comprising a further wire which is arranged between the two power wires and used for a further use.

A eighteenth invention is a battery unit according to any one of the fifteenth to seventeenth inventions, further comprising a projecting portion (158) which is formed on one of the second ends to draw out the power wires from the main body and the signal wire and fits to a cut-away portion formed on one of the second sides.

A nineteenth invention is a second battery unit which is used replacing with a first battery unit in a hand-held electronic device having a housing capable of being held by one hand or both hands, an attaching portion which is provided in a battery accommodating portion formed on the housing in a rectangular shape defined by two first sides and two second sides shorter than the first sides, and a concave portion which is formed on at least one of the first sides of the attaching portion with a predetermined height and a predetermined width, wherein the first battery unit includes a main body which has two first ends each having a length according to a total length of a length of one of the second sides and the height of the concave portion and two second ends shorter than the first ends, and the first battery unit is attached to the attaching portion in a manner that one of the second ends of the main body is along with the concave portion, comprising: a main body which has two first ends each having a length according to a length of one of the second sides of the attaching portion and two second ends each having a length according to a length of one of the first sides of the attaching portion, wherein the second battery unit is attached to the attaching portion in a manner that the first ends of the main body are along with the first sides and the second ends are along with the second sides.

The above described objects and other objects, features, aspects and advantages of the embodiments will become more apparent from the following detailed description of the embodiments when taken in conjunction with the accompanying drawings.

### BRIEF DESCRIPTION OF THE DRAWINGS

Figure 1 is an appearance view showing a non-limiting example of a hand-held electronic device using a battery.
Figure 2 is a top plan view showing a battery accommodating portion in the embodiment shown in Figure 1.
Figure 3 is an appearance view exemplifying a non-limiting example of a battery unit capable of being accommodated in a battery accommodating portion shown in Figure 1 and Figure 2, and Figure 3(a) and Figure 3(b) are perspective views respectively viewed from different directions.
Figure 4 is an appearance view exemplifying a non-limiting example of a further battery unit capable of being accommodated in a battery accommodating portion shown in Figure 1 and Figure 2, and Figure 4(a) and Figure 4(b) are perspective views respectively viewed from different directions.
Figure 5 is a perspective view showing a non-limiting example of a wire of the battery unit and a non-limiting example of a connector attached to a tip end of the wire.
Figure 6 is a top plan view showing a state that the battery unit shown in Figure 3 is attached to the attaching portion.
Figure 7 is a top plan view showing a further state that the battery unit shown in Figure 4 is attached to the attaching portion.
Figure 8 is an illustrative view showing a state that the battery unit is intended to be attached to the attaching portion in a reverse direction.

### DETAILED DESCRIPTION OF NON-LIMITING EXAMPLE EMBODIMENTS

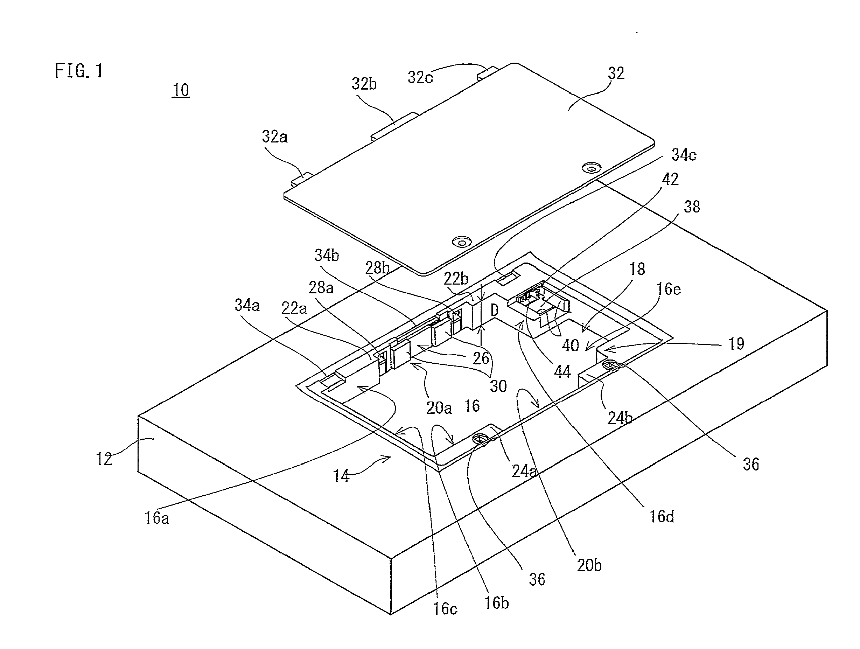

With referring to drawings, in the following, a non-limiting example of a hand-held electronic device using a battery (hereinafter, may be simply called as "electronic device") 10 will be described. The electronic device 10 shown in Figure 1 includes a housing 12, and the housing 12 has a size capable of being held by a user with one hand or both hands.

A battery accommodating portion 14 is formed on a rear surface of the housing 12, and inside the housing 12, although not shown, an electric circuitry and components which operate with being applied with an electric power from a battery (not shown in Figure 1) accommodated in the battery accommodating portion 14 are provided. In some cases, on a front surface of the housing 12, a display which is driven by the battery and displays an output from the electric circuitry and the components may be provided.

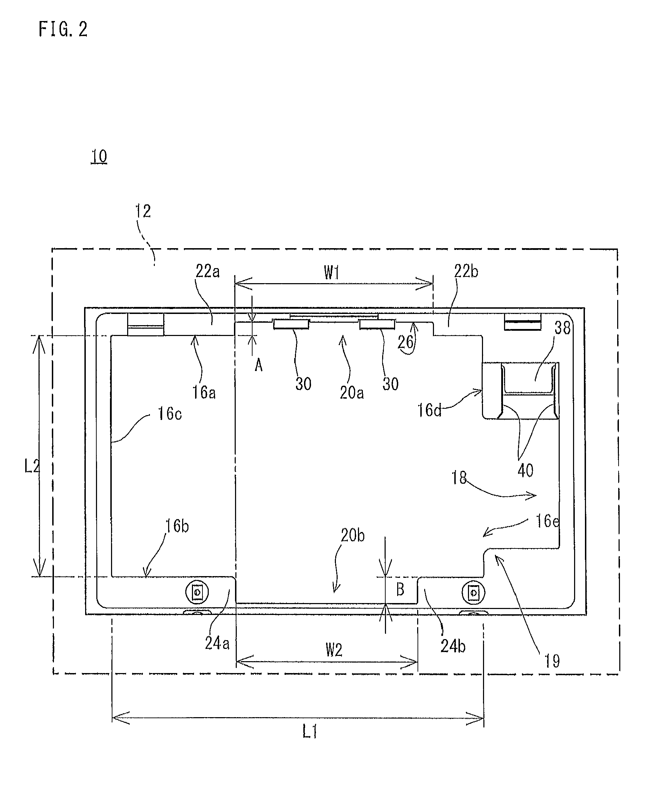

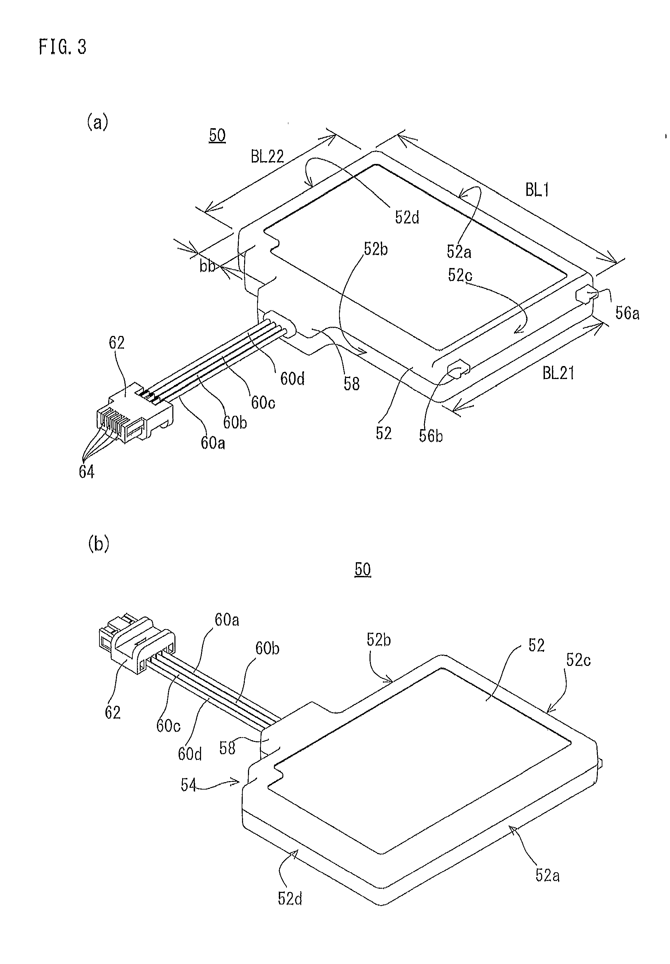

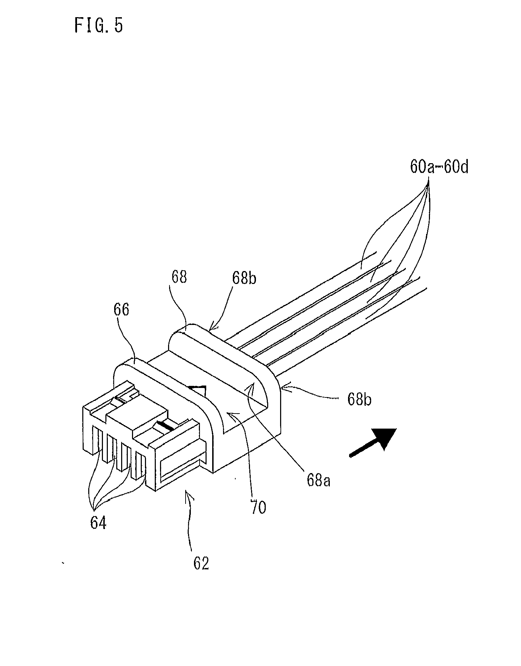

An attaching portion 16 which is for attaching a battery unit 50 and a battery unit 150 (Figure 3 and Figure 5: described later) and has a box shape with bottom is formed in the battery accommodating portion 14. The attaching portion 16 has a rectangular plane shape being horizontally long as a whole, as clearly understood from Figure 2, and a predetermined depth D capable of receiving the battery unit having a thickness. The attaching portion 16 is, in this embodiment shown, defined by an upper and lower relatively long inner sides 16a and 16b and left and right relatively short inner sides 16c and 16d, and a part of the right side 16d is cut away, and the attaching portion 16 and a wire accommodating portion 18 are communicated with each other through such a cut-away portion 16e. In addition, a corner portion 19 is formed at a lower end of the cut-away portion 16e.

A length of each of the upper and lower first sides 16a and 16b of the attaching portion 16 is L1, and a length of each of the left and right second sides 16c and 16d is L2.

As clearly understood from Figure 2 especially, a first concave portion 20a with a width of W1 and a height of A is formed on the upper first sides 16a having the length L1 of the attaching portion 16, and a second concave portion 20b with a width of W2 and a height of B is formed on the lower first sides 16b having the length L1 of the attaching portion 16. Both ends of the first concave portion 20a are defined by left and right corner portions 22a and 22b, and both ends of the second concave portion 20b are defined by left and right corner portions 24a and 24b. In addition, in this embodiment, the width W1 of the first concave portion 20a is larger than the width W2 of the second concave portion 20b (W1>W2), but left ends of the first concave portion 20a and the second concave portion 20b are set at the same horizontal position. That is, the first concave portion 20a is wider than the second concave portion 20b, a center of the width W1 of the first concave portion 20a and a center of the width W2 of the second concave portion 20b are deviated from each other in the horizontal direction, and the former exits slightly right in comparison with the latter. That is, the left and the right of the first concave portion 20a are respectively defined by the corner portions 22a and 22b and the left and the right of the second concave portion 20b are respectively defined by the corner portions 24a and 24b, and one corner portion 22a defining the first concave portion 20a and one corner portion 24a defining the second concave portion 20b are formed at corresponding positions (that is, positions aligned in the vertical direction), and the other corner portion 24b defining the second concave portion 20b is formed at a position inner than a position of the other corner portion 22b defining the first concave portion 20a.

By making the width W1 of the first concave portion 20a and the width W2 of the second concave portion 20b different from each other, it is possible to prevent an error in attaching the first batter unit 50 described later. That is, by distinguishing which one of the widths is shorter, a correct attaching direction can be recognized, and even if the first battery unit 50 is intended to be erroneously attached, the first battery unit cannot be put-in, and therefore, an reverse attaching can be prevented.

As shown in Figure 1, two holes 28a and 28b are formed at both ends of a deeper wall 26 defining the height of the first concave portion 20a, which are for receiving projections 56a and 56b (Figure 3) formed to be projected on one side of the first battery unit 50 described later. Then, on the deeper wall 26 inner than the holes 28a and 28b, there is provided a spacer 30 made of an elastic material such as a synthetic resin foam by adhesive.

In a battery accommodating portion 14 of the rear surface of the housing 12, above an upper side 16a of the attaching portion 16, holes 34a, 34b and 34c for being inserted with claws 32a, 32b and 32c of a battery lid 32 are formed, and outside the lower side 16b of the attaching portion 16, holes 36 for fixing the battery lid 32 with screws are formed. In addition, the screws are tapping screws in this embodiment, no female screw is formed in each of holes 36, but each of the holes 36 may be formed with a female screw.

A circuit board 38 for the aforementioned electric circuitry is exposed in the upper portion of the wire accommodating portion 18 communicating with the attaching portion 16 through the cut-away portion 16e, and sandwiching the circuit board 38, guide surfaces 40 are formed at both sides.

A female connector 42 is provided in a deeper portion of the guide surface 40, that is, an upper end of the wire accommodating portion 18. The female connector 42 involves or contains a plurality of (four (4), in this embodiment) connecting terminals 44 which are electrically connected to required portions of the above-described electric circuitry. Such a female connector 42 is fixed to the circuit board 38 by soldering.

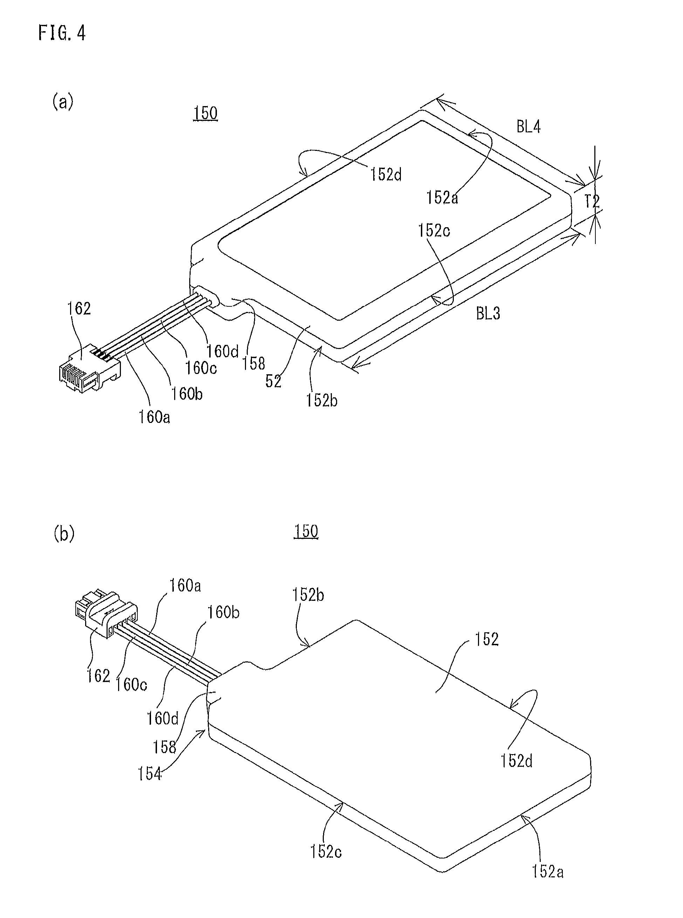

Two kinds of battery units 50 and 150 to be accommodated in the battery accommodating portion 14 shown in Figure 1 and Figure 2 are shown in Figure 3 and Figure 4, respectively.

The battery unit 50 shown in Figure 3 includes a vertically-long main body 52 having first ends 52a and 52b forming a longer side (first side) and second ends 52c and 52d forming a shorter side (second side), and although not shown, within the main body 52, a rechargeable battery such as a lithium ion battery, a temperature detecting device (a thermistor, for example) and a control circuit are incorporated. A length of each of the first ends 52a and 52b of the main body is BL1, a length of the upper second end 52c is BL21, and a length of the lower second end is BL22. A thickness of the main body 52 is T1. Here, this thickness T1 is set in accordance with the depth D of the attaching portion 16 shown in Figure 1. The thickness T1 is set to be equal to or slightly smaller than the depth D (T1=<D).

A step portion 54 is formed at a lower right corner where the right first end 52b of the main body 52 and the lower second end 52d are intersected to each other. The step portion 54 has a shape capable of engaging to the right corner portion 24b of the second concave portion 20b formed on the first side 16b of the aforementioned attaching portion 16. That is, in the step portion 54, over a distance bb from the lower end of the right first end 52b, the length BL22 of the lower second end 52d is made shorter than the length BL21 of the upper second end 52c (BL21>BL22). The distance bb is set to be equal to or slightly shorter than the height B of the second concave portion 20b formed on the first side 16b of the attaching portion 16 shown in Figure 2 (bb=<B).

Furthermore, the length BL21 of the upper second end 52c of the above-described main body 52 is set in accordance with the width W1 of the first concave portion 20a formed on the upper first side 16a defining the attaching portion 16. Specifically, the length BL21 is set to be approximately the same as, that is, to be equal to or slightly shorter than the width W1 (BL21=<W1). The length BL22 of the lower second end 52d of the main body 52 is set in accordance with the width W2 of the second concave portion 20b formed on the lower first side 16b defining the attaching portion 16. Specifically, the length BL22 is set to be approximately the same as, that is, to be equal to or slightly shorter than the width W2 (BL22=<W2). A difference between the width W1 of the concave portion 20a and the width W2 of the concave portion 20b becomes equal to a difference between the length BL21 of the upper second end 52c and the length BL22 of the lower second end 52d.

On the other hand, the length BL1 of the first side of the main body 52 is longer than a length of each of the left and right second sides 16c and 16d defining the attaching portion 16, i.e., the length L2 of the shorter sides of the attaching portion 16 (BL1>L2), but set to be a length in accordance with a total length (L2+A+B) of the length L2, the height A of the first concave portion 20a and the height B of the second concave portion 20b (equal to or slightly shorter than the total length) (BL1=<(L2+A+B)).

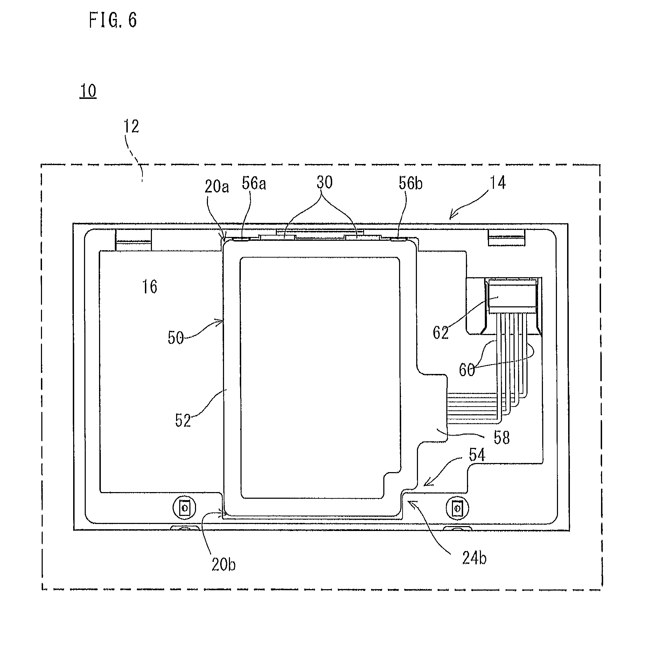

In other words, the main body 52 of the battery unit 50 can be attached to the attaching portion 16 in a vertically-long direction, as shown in Figure 6, by fitting the upper second end 52c and the lower second end 52d to the first concave portion 20a and the second concave portion 20b of the attaching portion 16, respectively,

Two projections 56a and 56b projected upward are formed at left and right ends of the upper second side of the main body 52. The projections 56a and 56b are engaged to the aforementioned two holes 28a and 28b formed in the first concave portion 20a of the upper first sides 16a of the attaching portion 16.

A projecting portion 58 which is projected toward right is formed on a lower right portion of the first side of the main body 52, and through the projecting portion 58, four (4) (in this embodiment) wires 60a, 60b, 60c and 60d are drawn-out. Out of the four wires, the wire 60a is a red color wire, for example, and outputs a plus (+) of a battery voltage, and the wire 60b is a grey color wire, for example, and outputs an output signal of the above-described temperature detecting device, and the wire 60c is a black color wire, for example, and outputs a minus (-) of the battery voltage, and the wire 60d is a white color wire, for example, and outputs an identification signal (described later) of the battery unit. However, a further arrangement of wires, for example, an arrangement where the wire 60a may be a white color wire which outputs the identification signal, the wire 60b may be a black color wire which outputs the minus (-) of the battery voltage, the wire 60c may be a grey color wire which outputs the output signal of the temperature detecting device, and the wire 60d may be a red color wire which outputs the plus (+) of the battery voltage may be adopted.

In addition, positions of the while color identification signal wire and the grey color temperature detection outputting wire may be exchanged. In any cases, between one power wire (red color plus outputting wire) and the identification signal outputting wire, there is inserted with the other power wire (black color minus outputting wire).

At the tip ends of the wires 60a-60d, a male connector 62 is attached (provided). That is, the main body 52 and the male connector 62 are coupled to each other via the wires 60a-60d. The male connector 62 includes four (4) connecting terminals 64. Each of the connecting terminals 64 is electrically and mechanically connected to each of the blade terminal 44 by sandwiching the blade terminal 44 of the female connector 42 at both sides. If the male connector 62 is pushed along with the guide surfaces 40 to insert (connect) to the female connector 42, each terminal 64 sandwiches the corresponding terminal 44, whereby the terminal 64 can be connected to the terminal 44.

Here, with referring to Figure 5, the male connector 62 will be described. On an upper surface of the male connector 62, there are formed with two (2) rising pieces 66 and 68 with an interval, and a concave portion 70 is formed between the rising pieces 66 and 68. By putting a finger tip in the concave portion 70 and moving the finger tip in a direction that the male connector 62 is disconnected (in an arrow mark direction: downward direction in the embodiment), the male connector 62 can be disconnected from the female connector 42. At this time, the finger tip abuts an inside surface (inner surface) 68a of the rising piece 68. Accordingly, the rising piece 68 functions as a handle or knob for disconnecting the male connector 62.

In addition, in order to connect the male connector 62 to the female connector 42, an outer surface 68b of the rising piece 68 may be pushed by a finger in a direction opposite to the arrow mark.

Furthermore, it is possible to function the rising piece 66 as a handle or knob. In such a case, the male connector 62 may be moved in the arrow mark direction in a state that the rising piece 66 is held with fingers.

The battery unit 150 shown in Figure 4 includes a horizontally-long main body 152 which includes left and right first ends 152a and 152b forming shorter sides and upper and lower second ends 152c and 152d forming longer sides, and although not shown, within the main body 152, a rechargeable battery such as a lithium ion battery, a temperature detecting device (a thermistor, for example) and a control circuit are incorporated. A length of each of the second sides 152c and 152d is BL3 and a length of each of the first sides 152a and 152b is BL4. A thickness of the main body 152 is T2. Here, this thickness T2 is set in accordance with the depth D of the attaching portion 16 shown in Figure 1. The thickness T1(T2) is set to be equal to or slightly smaller than the depth (T2=<D). Furthermore, the thickness T2 of the main body 152 of the battery unit 150 is set to be equal to or approximately equal to the thickness T1 of the main body 52 of the battery unit 50. Accordingly, as described later, even if either the first battery unit 50 or the second battery unit 150 is attached to the attaching portion 16, it is not necessary to change a battery lid, and therefore, it is possible to accommodate the battery unit using the same battery lid 32 (Figure 1).

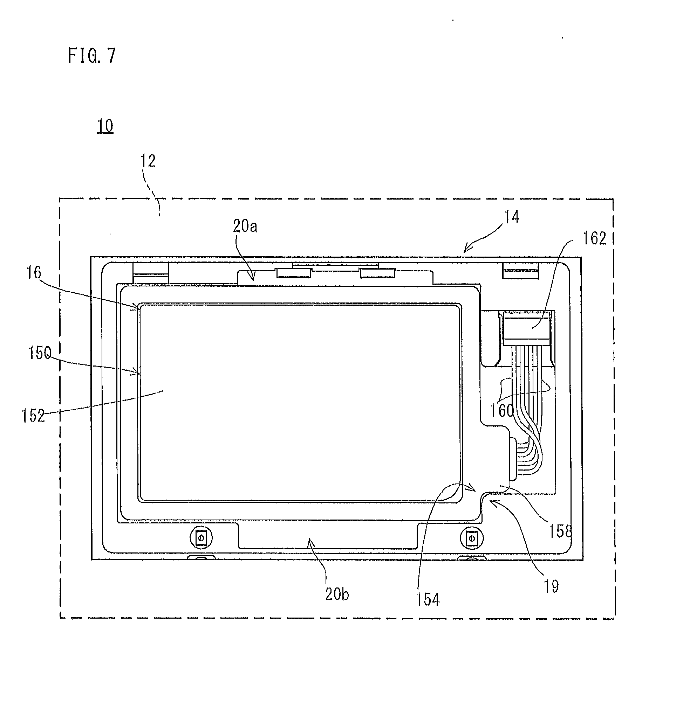

Furthermore, the length BL3 of each of the second sides 152c and 152d of the main body 152 is set in accordance with the length L1 of each of the upper and lower first sides 16a and 16b defining the attaching portion 16, that is, the length L1 of each of the first sides (longer sides) of the attaching portion 16. Specifically, the length BL3 is set equal to or slightly shorter than the length L1. That is, the length BL3 is set to be equal to or slightly shorter than the length L1 (BL3=<L1). The length BL4 of each of the first sides 152a and 152b of the main body 152 is set in accordance with the length L2 of each of the left and right second sides 16c and 16d of the attaching portion 16, that is, the length L2 of each of the second sides (shorter sides) defining the attaching portion 16. Specifically, the length BL4 is set equal to or slightly shorter than the length L2 (BL4=<L2). Therefore, the main body 152 of the battery unit 150 can be attached to the attaching portion 16 in a horizontally-long direction as shown in Figure 7 by fitting the second ends 152c and 152d and the first ends 152a and 152b to the longer side (the first sides 16a and 16b) and the shorter side (the second sides 16c and 16d), respectively.

In addition, the length BL3 of each of the second ends 152c and 152d of a large-sized battery unit 150 shown in Figure 4 is, of course, longer than the length BL1 of each of the first ends 52a and 52b of a small-sized battery unit 50.

A projecting portion 158 projected toward right is formed on a lower right portion of the second side 152b of the main body, and through the projecting portion 158, four (4) (in this embodiment) wires 160a, 160b, 160c and 160d are drawn-out. A step portion 154 is formed below the projecting portion 158.

Out of the four wires, the wire 160a is a red color wire, for example, and outputs (+) of a battery voltage, and the wire 160b is a grey color wire, for example, and outputs an output signal of the above-described temperature detecting device, and the wire 160c is a black color wire, for example, and outputs (-) of the battery voltage, and the wire 160d is a white color wire, for example, and outputs an identification signal (described later) of the battery unit. However, as similar to the wire arrangement of the first battery unit 52, such the wire arrangement may be substituted with a further wire arrangement.

At the tip ends of the wires 160a-160d, a male connector 162 is attached. The male connector 162 includes four (4) connecting terminals 164. Each of the connecting terminals 164 is electrically and mechanically connected to each of the blade terminal 44 by sandwiching the blade terminal 44 of the female connector 42 at both sides. If the male connector 162 is pushed along with the guide surfaces 40 to insert to the female connector 42, each terminal 164 sandwiches the corresponding terminal 44 whereby the terminal 164 can be connected to the terminal 44.

Each of the wire 60d of the battery unit 50 shown in Figure 3 and the wire 160d of the battery unit 150 shown in Figure 5 is an identification signal outputting wire, and here, the identification signal outputting wire will be described.

This embodiment is constructed such that two kinds of the battery units different from each other in size and/or shape such as the battery unit 50 of Figure 3 and the battery unit 150 of Figure 5 can be attached to a single battery accommodating unit 14, i.e., the attaching portion 16. In the embodiment, since the battery unit 150 is larger than the battery unit 50, and therefore, the battery unit 50 and the battery unit 150 are different from each other in battery capacity.

On the other hand, in the electronic device 10 of the embodiment, if a residual battery quantity becomes low, the battery unit is to be charged. The charging must be controlled most suitably in a battery characteristic (a charging characteristic) of the battery unit, and therefore, between the battery units having different battery capacities as described above, of course, the battery characteristics are different from each other. Therefore, a computer (not shown) which is housed in the electronic device 10 and in charge of a charge control must correctly recognize whether the battery unit being currently attached is the battery unit 50 or the battery unit 150.

Therefore, in order to identify two kinds of the battery units different from each other in size and/or shape, that is, in order to identify a first battery unit or a second battery unit, in either the battery unit 50 and the battery unit 150, from the lowermost wire 60d or 160d, an identification signal unique to each battery unit is output. By detecting such a unique identification signal, the computer (not shown) of the electronic device 10 can correctly judge or determine whether the first battery unit is attached or the second battery unit is attached.

In this embodiment, by forming a register circuit in the control circuit (not shown) within the battery unit, the battery unit 50 and the battery unit 150 output from the wire 60d and the wire 160d inherent resistance values (current values or voltage values) as the identification signal. Then, the above-described computer identifies the battery unit 50 or the battery unit 150 based on the resistance value (current value or voltage value).

If it is necessary to identify the battery unit 50 or the battery unit 150 only, only two different resistance values (current values or voltage values) may be output from the identification signal wires 60d and 160d; however, in a case that the battery unit 50 is manufactured by two or more different manufacturers or a case that the battery unit 150 is manufactured by two or more different manufacturers, it is necessary to identify a manufacturer. This is because, even if the battery units have the same battery capacity, the above-described battery characteristics (charging characteristics) is different for each manufacturer, and therefore, in order to correctly charge the battery unit, it is necessary to correctly identify both the manufacturer and the battery capacity. If the manufacturer and the battery capacity are to be identified, it is necessary to classify more finely the resistance value (current value or voltage value) rendered as the identification signal. For example, in a case that the battery unit 50 and the battery unit 150 are respectively manufactured by two manufacturers, the resistance value (current value or voltage value) output from the signal wire 60d or 160d is to be identified in at least four steps.

By detecting such a unique identification signal, it is possible for the computer (not shown) of the electronic device 10 to correctly judge or determine not only either one of the first battery unit and the second battery unit is being attached but also a manufacturer of the first battery unit and a manufacturer of the second battery unit.

With referring to Figure 6, by slightly inclining the main body 52 in a manner that the upper second end 52c of the main body 52 of the battery unit 50 is directed downward (depth in the paper surface of Figure 6) and the lower second end 52d is directed upward (this side in the paper surface of Figure 6), the projections 56a and 56b formed on the upper second end 52c are respectively inserted to the corresponding holes 28a and 28b, and then, by fitting the upper and lower second ends 52c and 52d to the first concave portion 20a and the second concave portion 20b of the attaching portion 16, it is possible to attach the battery unit 50 to the attaching portion 16 of the battery accommodating portion 14. At this time, since the projections 56a and 56b are inserted to the holes 28a and 28b, and the lower right step portion 54 of the main body 52 is engaged to the corner portion 24b defining the second concave portion 20b, a displacement or movement of the main body 52 in the horizontal direction can be suppressed.

Furthermore, since the spacer 30 is brought into contact with an end surface of the upper second end 52c of the main body 52, that is, since the spacer 30 is inserted between the deeper side 26 (Figure 1 and Figure 2) of the first concave portion 20a and the end surface of the second end 52c and the spacer 30 is an elastic member, a displacement or movement of the main body 52 in the vertical direction can be suppressed.

In addition, wires 60 drawn out from the main body 52 are suitably connected electrically to an electric circuit and components (not shown) provided on the circuit board 38 via the connectors 62 and 42 (Figure 1). At this time, the male connector 62 is connected to the female connector 42 in a state that the wires 60 are twisted once, that is, in a manner that the rising pieces 66 and 68 of the male connector 62 are rendered up.

With referring to Figure 7, by respectively fitting the first ends 152a and 152b of the main body 152 of the battery unit 150 to the shorter sides of the attaching portion 16 and the second ends 152c and 152d to the longer sides of the attaching portion 16, and then, pushing-in the main body 152 as it is, it is possible to attach the battery unit 150 to the attaching portion 16 of the battery accommodating portion 14. At this time, since the lower right step portion 154 of the main body 152 is engaged to the corner portion 19 defining the lower end of the cut-away portion 16e, a displacement or movement of the main body 152 in the horizontal direction can be suppressed. In addition, a displacement or movement of the main body 152 in the vertical direction can be suppressed by the upper and lower first sides 16a and 16b defining the attaching portion 16. Furthermore, since the projecting portion 158 for drawing-out the wires 160 from the main body 152 is fit to the cut-away portion 16e as shown in Figure 7, the displacement or movement of the main body 152 in the vertical direction can be further suppressed.

In addition, the wires 160 drawn out from the main body 152 are suitably connected electrically to the electric circuit or components (not shown) provided on the circuit board 38 via the connectors 162 and 42 (Figure 1).

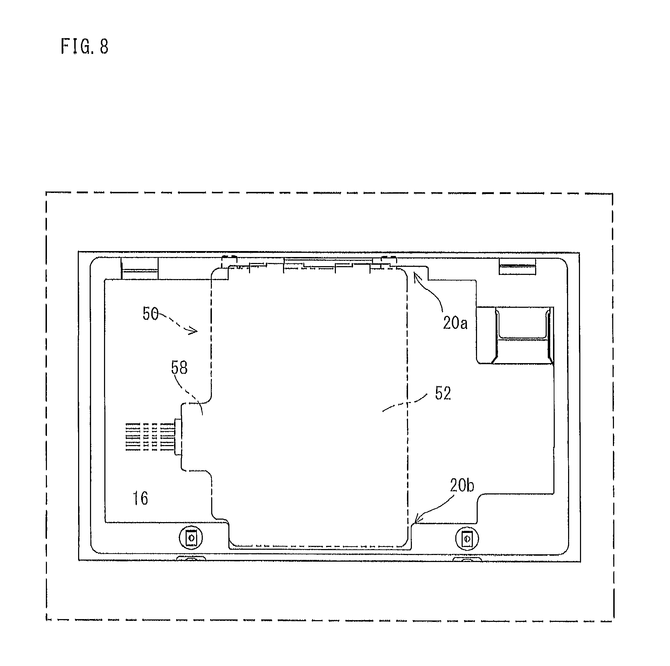

In a case that the battery unit 50 is to be attached to the attaching portion 16 as shown in Figure 6, the projecting portion 58 is directed rightward, but if the battery unit 50 is intended to be attached while reversed left and right as shown in Figure 8, the second end 52d of the main body 52 of the battery unit 50 can be fit in the second concave portion 20b, but the second end 52c overreaches the first concave portion 20a at a left side. This is because the center of the first concave portion 20a and the center of the second concave portion 20b are deviated from each other as described above. Since the upper second end 52c of the main body 52 thus overreaches the first concave portion 20a, the projections 56a and 56b cannot be inserted to the holes 28a and 28b. Thus, it is ensured that the battery unit 50 is correctly attached to the attaching portion 16.

In addition, in the above-described embodiment, the temperature detecting device is incorporated within the battery unit 50 (150) and the temperature detection signal is output from the wire 60b (160b); however, in a case that the temperature detecting device is provided outside the battery unit, the wire 60b (160b) may not be provided.

Furthermore, in order to attach the small sized battery unit 50 to the attaching portion 16 in a vertically-long direction, the first concave portion 20a and the second concave portion 20b are formed an upper side and a lower side of the attaching portion 16 so as to receive the upper and lower second ends 52c and 52d of the main body 52, and the first side length BL1 of the main body 52 is received in the length (L2 + A + B) that the height A and B of the first concave portion 20a and the second concave portion 20b are added to the shorter sides' length L2 of the attaching portion 16. That is, by forming concave portions at an upper side and a lower side, the main body 52 of the battery unit 50 can be attached in the vertically-long direction to the horizontally-long attaching portion 16. Only one of the concave portions may be provided, but in such a case, if the height of a single concave portion is C, it is necessary to be set to satisfy BL1 ≤ L2 + C).

However, as exemplified in this embodiment shown, when the second ends of the main body 52 of the first battery unit 50 are respectively fit to the two concave portions 20a and 20b, stability in attaching the first battery unit 50 to the attaching portion 16 increases.

Furthermore, in the above-described embodiment, in the main body 52 of the first battery unit 50, the step portion 54 is formed, but this step portion may not be provided. In such a case, the lengths of the upper second end 52c and the lower second end 52d of the main body 52 becomes the same. Therefore, the widthW1 of the first concave portion 20a and the width W2 of the second concave portion 20b may be set the same in the attaching portion 16.

In the above-described embodiment, the holes 28a and 28b are formed in a deeper portion of the first concave portion 20a, and projections 56a and 56b are formed on the second end 52c of the main body 52 of the first battery unit 50 and in attaching the battery unit, these are engaged to each other in attaching the battery unit. However, the holes 28a and 28b may be formed in a deeper portion of the concave portion 20b and the projections 56a and 56b are formed on the second end 52d of the main body 52 of the first battery unit 50, and these may be engaged to each other.

In addition, the projections 56a and 56b may not be provided, and only one of the projections may be provided.

While certain example systems, methods, storage media, devices and apparatuses have been described herein, it is to be understood that the appended claims are not to be limited to the systems, methods, storage media, devices and apparatuses disclosed, but on the contrary, are intended to cover various modifications and equivalent arrangements included within the spirit and scope of the appended claims.

## Claims

1. A hand-held electronic device (10) having a housing (12) capable of being held by one hand or both hands, and a battery unit is accommodated within a battery accommodating portion (14) provided on the housing, comprising:
an attaching portion (16) which is provided in the battery accommodating portion in a rectangular shape defined by two first sides (16a, 16b) and two second sides (16c, 16d) each of which is shorter than each of the first sides;
a concave portion (20 or 20b) which is formed on at least one of the first sides (16a or 16b) of the attaching portion with a predetermined height (A or B) and a predetermined width (W1 or W2); and
a first battery unit (50) or a second battery unit (150) capable of selectively being attached to the attaching portion, wherein
the first battery unit (50) includes a main body (52) which has two first ends (52a, 52b) each having a length according to a total length of a length (L2) of one of the second sides (16c, 16d) of the attaching portion and the height (A or B) of the concave portion (20a or 20b) and two second ends each of which is shorter than each of the first ends,
the second battery unit (150) includes a main body (152) which has two first ends (152a, 152b) each having a length according to a length (L2) of one of the second sides (16c, 16d) of the attaching portion and two second ends (152c, 152d) each having a length according to a length (L1) of one of the first sides (16a, 16b) of the attaching portion, and
the first battery unit (50) is attached to the attaching portion (16) in a manner that one of the second ends of the main body (52) is along with the concave portion (20a or 20b) and the second battery unit (150) is attached to the attaching portion (16) in a manner that the first ends of the main body (152) are along with the second sides (16c, 16d) and the second ends are along with the first sides (16a, 16b).

2. A hand-held electronic device according to claim 1, wherein the first battery unit includes longer sides formed by the first ends and the second battery unit includes longer sides formed by the second ends, and the first battery unit or the second battery unit is attached to the attaching portion (16) in a manner that the longer sides of the first battery unit and the longer sides of the second battery unit are intersected to each other.

3. A hand-held electronic device according to claim 1 or 2, wherein the attaching portion (16) includes a first concave portion (20a) and a second concave portion (20b) respectively formed at corresponding positions on the two first sides (16a, 16b), and the two second ends (52c, 52d) of the main body (52) of the first battery unit (50) are received by the first concave portion (20a) and the second concave portion (20b), respectively.

4. A hand-held electronic device according to claim 3, wherein the first concave portion and the second concave portion are different from each other in width.

5. A hand-held electronic device according to any one of claims 1 to 4, wherein a left and a right of the first concave portion (20a) are respectively defined by corner portions (22a, 22b) and a left and a right of the second concave portion (20b) are respectively defined by corner portions (24a, 24b), one (22a) of the corner portions defining the first concave portion and one (24a) of the corner portions defining the second concave portion are formed at corresponding positions, and another (24b) of the corner portions defining the second concave portion is formed at a position inner than another (22b) of the corner portions defining the first concave portion.

6. A hand-held electronic device according to claim 5, wherein one of the second ends of the first battery unit (50) is formed with a step portion (54) which is engaged to the corner portions.

7. A hand-held electronic device according to any one of claims 1 to 6, wherein the sides defining the attaching portion (16) have a predetermined depth (D) and the main body (52, 152) of each of the first battery unit (50) and the second battery unit (152) has a thickness (T1, T2) according to the depth.

8. A hand-held electronic device according to any one of claims 1 to 7, wherein each of the first battery unit (50) and the second battery unit (150) includes power wires (60a, 60c, 160a, 160c) which output a battery voltage and a signal wire (60d, 160d) which outputs an identification signal for identifying the first battery unit or the second battery unit.

9. A hand-held electronic device according to any one of claims 1 to 8, wherein one (16d) of the second sides is formed with a cut-away portion (16e), and each of the first battery unit (50) and the second battery unit (150) includes a projecting portion (58, 158) which is formed on the main body (52, 152) at a position corresponding to the cut-away portion (16e) to draw the power wires and the signal wire.

10. A battery unit (50) used in a hand-held electronic device (10) having a housing (12) capable of being held by one hand or both hands, an attaching portion (16) which is provided in a battery accommodating portion (14) formed on the housing (12) in a rectangular shape defined by two first sides (16a, 16b) and two second sides (16c, 16d) shorter than the first sides and a concave portion (20a or 20b) which is formed on at least one of the first sides (16a, 16b) of the attaching portion with a predetermined height (A or B) and a predetermined width (W1 or W2), comprising:
a main body (50) which has two first ends (52a, 52b) each having a length according to a total length of a length (L2) of one of the second sides (16c, 16d) and the height (A or B) of the concave portion (20a or 20b) and two second ends (52c, 52d) shorter than the first ends, wherein
the battery unit (50) is attached to the attaching portion (16) in a manner that one of the second ends (52c, 52c) of the main body (52) is along with the concave portion (20a or 20b).

11. A battery unit according to claim 10, wherein the attaching portion (16) of the hand-held electronic device (10) includes a first concave portion (20a) and a second concave portion (20b) respectively formed at corresponding positions on the two first sides (16a, 16b), and the two second ends (52c, 52d) of the main body (52) of the battery unit are received by the first concave portion (20a) and the second concave portion (20b), respectively.

12. A battery unit according to claim 11, wherein a left and a right of the first concave portion (20a) are respectively defined by corner portions (22a, 22b) and a left and a right of the second concave portion (20b) are respectively defined by corner portions (24a, 24b), one (22a) of the corner portions defining the first concave portion (20a) and one (24a) of the corner portions defining the second concave portion (20b) are formed at corresponding positions, and another (22b) of the corner portions defining the first concave portion (20a) is formed at a position inner than another (24b) of the corner portions defining the second concave portion (20b), and one of the second ends (52b) of the main body (52) is formed with a step portion (54) which is engaged to said another(24b) of the corner portions defining the second concave portion (20b).

13. A battery unit according to claim 11 or 12, wherein a hole (28a, 28b) is formed in a deeper portion (26) of one of the first concave portion (20a) and the second concave portion (20b), further comprising a projection (56a, 56b) which is formed on one (of the two second ends (52c, 52d) and engaged to the hole (28a, 28b) when the battery unit (50) is attached to the attaching portion (16).

14. A battery unit according to any one of claims 10 to 13, further comprising power wires (60a, 60c) which output a battery voltage and a signal wire (60d) which outputs a unique identification signal; and a projecting portion (58) formed on one of the first ends to draw out the power wires and the signal wire from the main body.

15. A battery unit (150) used in a hand-held electronic device (10) having a housing (12) capable of being held by one hand or both hands, an attaching portion (16) which is provided in a battery accommodating portion (14) formed on the housing (12) in a rectangular shape defined by two first sides (16a, 16b) and two second sides (16c, 16d) shorter than the first sides and a concave portion (20a or 20b) which is formed on at least one of the first sides (16a, 16b) of the attaching portion (16) with a predetermined height (A or B) and a predetermined width (W1 or W2), comprising:
a main body (152) which has two first ends (152a, 152b) each having a length according to a length (L2) of one of the second sides (16c, 16d) of the attaching portion (16) and two second ends (152c, 152) each having a length according to a length (L1) of one of the first sides (16a, 16b) of the attaching portion (16), wherein
the battery unit (150) is attached to the attaching portion (16) in a manner that the first ends (152a, 152b) of the main body (152) are along with the first sides (16a, 16b) and the second ends (152c, 152d) are along with the second sides (16c, 16d).

16. A battery unit according to claim 15, further comprising two power wires which output a battery voltage and a signal wire which outputs a unique identification signal.

17. A battery unit according to claim 16, further comprising a further wire which is arranged between the two power wires and used for a further use.

18. A battery unit according to ay one of claims 15 to 17, further comprising a projecting portion (158) which is formed on one of the second ends to draw out the power wires from the main body and the signal wire and fits to a cut-away portion (16e) formed on one (16d) of the second sides.

19. A second battery unit (150) which is used replacing with a first battery unit (50) in a hand-held electronic device (10) having a housing (12) capable of being held by one hand or both hands, an attaching portion (16) which is provided in a battery accommodating portion (14) formed on the housing (12) in a rectangular shape defined by two first sides (16a, 16b) and two second sides (16c, 16d) shorter than the first sides, and a concave portion (20a or 20b) which is formed on at least one of the first sides (16a, 16b) of the attaching portion (16) with a predetermined height (A or B) and a predetermined width (W1 or W2), wherein the first battery unit (50) includes a main body (52) which has two first ends (52a, 52b) each having a length according to a total length of a length (L2) of one of the second sides (16c, 16d) and the height (A or B) of the concave portion (20a or 20b) and two second ends (52c, 52d) shorter than the first ends, and the first battery unit (50) is attached to the attaching portion (16) in a manner that one of the second ends (52c, 52d) of the main body (52) is along with the concave portion (20a or 20b), comprising:
a main body (152) which has two first ends (152a, 152b) each having a length according to a length (L2) of one of the second sides (16c, 16d) of the attaching portion (16) and two second ends (152c, 152d) each having a length according to a length (L1) of one of the first sides (16a, 16b) of the attaching portion (16), wherein
the second battery unit (150) is attached to the attaching portion (16) in a manner that the first ends (152a, 152b) of the main body (152) are along with the first sides (16a, 16b) and the second ends (152c, 152d) are along with the second sides (16c, 16d).
